# EUROPÄISCHE PATENTSCHRIFT

(11) **EP 2 659 279 B1**
(45) Veröffentlichungstag und Bekanntmachung des Hinweises auf die Patenterteilung: **26.12.2018**
(21) Anmeldenummer: 12714525.8
(22) Anmeldetag: 12.03.2012
(51) Int. Cl.: G01R 31/26, G01R 31/28

(54) **VORRICHTUNG ZUM HOCHSPANNUNGSPRÜFEN VON HALBLEITERBAUELEMENTEN**
DEVICE FOR HIGH VOLTAGE TESTING OF SEMICONDUCTOR COMPONENTS
DISPOSITIF POUR L'ESSAI HAUTE TENSION DE DISPOSITIFS À SEMI-CONDUCTEURS

(30) Priorität: 17.03.2011 AT 3712011
(43) Veröffentlichungstag der Anmeldung: 06.11.2013
(73) Patentinhaber: Gaggl, Rainer, 9580 Drobollach (AT)
(72) Erfinder: Gaggl, Rainer, 9580 Drobollach (AT)
(74) Vertreter: Beer & Partner Patentanwälte KG
(86) Internationale Anmeldenummer: PCT/AT2012/000060
(87) Internationale Veröffentlichungsnummer: WO 2012/122578

(56) Entgegenhaltungen:
- WO-A1-2006/093349
- AT-B- 412 175
- DE-A1- 19 630 316
- DE-A1-102006 018 474

## Beschreibung

Die Erfindung betrifft eine Vorrichtung zum Hochspannungsprüfen von Halbleiterbauelementen, umfassend eine Druckkammer deren Innenraum über eine Druckgasleitung unter Überdruck gesetzt werden kann, wobei die Druckkammer an einer Nadelkarte mit Prüfnadeln angeordnet ist.

Im Rahmen der Erfindung in Betracht gezogen sind sowohl Halbleiterbauelemente (in der weiteren Folge als "Chip" bezeichnet), die noch nicht aus Halbleiterscheiben entfernt (herausgebrochen)sind, als auch bereits aus Halbleiterscheiben herausgetrennte, vereinzelte Chips.

Beim elektrischen Prüfen von Halbleiterbauelementen werden Hochspannungsbauelemente, wie z.B. Hochspannungstransistoren, IGBT's oder Dioden, durch Anlegen von Hochspannung auf ihre Spannungsfestigkeit geprüft. Dabei werden die Chips, die noch nicht in ein Gehäuse eingebaut sind und sich beispielsweise noch aneinander liegend (noch nicht vereinzelt) in einer Halbleiterscheibe befinden, über Prüfkontakte an den Kontaktflächen der Chipvorderseite bzw. eine leitfähige Trägerplatte auf der Chiprückseite mit elektrischer Hochspannung beaufschlagt und die elektrischen Eigenschaften, wie z.B. der Leckstrom bei gesperrtem Bauelement, gemessen.

Bei diesem Prüfen können abhängig von der Chipgeometrie und der Höhe der Prüfspannung zwischen Kontaktflächen am Chip so hohe elektrische Feldstärken auftreten, dass es zu unerwünschten (Funken-)Überschlägen zwischen Kontaktflächen und über die Atmosphäre (Luft) kommt. Die neben dem zu prüfenden, kontaktierten Chip liegenden, weiteren Chips auf einer Halbleiterscheibe werden auf der Chipvorderseite üblicherweise nicht kontaktiert, sodass bei diesen auch keine Funkenüberschläge auftreten.

Aus der AT 412 175 B ist eine Anordnung bekannt, mit der Funkenüberschläge beim Hochspannungsprüfen vermieden werden können, indem die Messung unter erhöhtem Gasdruck ausgeführt wird. Die AT 412 175 B nützt den Umstand aus, dass die Überschlagsfeldstärke vom Gasdruck abhängt, wobei die Zündspannung des Funkens mit steigendem Gasdruck zunimmt. Bei der aus der AT 412 175 B bekannten Vorrichtung wird der mit Hochspannung beaufschlagte Chip während des Messvorganges als Ganzes oder teilweise, wenigstens in den überschlagsgefährdeten Bereichen einem erhöhten Gasdruck (beispielsweise erhöhter Luftdruck) ausgesetzt. Bei genügend hohem Gasdruck kann die Zündspannung des Funkenüberschlages über die maximal am Prüfling anliegende Testspannung erhöht und Überschläge am Chip können wirkungsvoll unterdrückt werden. Bei der AT 412 175 B wird eine Druckkammer verwendet, die auf das zu prüfende Halbleiterbauelement (z.B. den Chip) aufgesetzt wird. Die einseitig offene Druckkammer wird durch Aufsetzen auf das Halbleiterbauelement geschlossen und in der Druckkammer über eine Druckgaszuführung über dem Prüfling Überdruck aufgebaut.

Das elektrische Kontaktieren des Prüflings erfolgt in der Regel über federnde Kontaktnadeln ("probes"), die für gewöhnlich auf einer Leiterplatte zum Zuführen der elektrischen Signale montiert sind. Eine solche Kontaktiervorrichtung wird auch als Nadelkarte ("probe card") bezeichnet. Die in der AT 412 175 B allgemein angesprochene Kombination einer Nadelkarte mit einer Druckkammer in einer Anordnung zum Hochspannungsprüfen von Halbleiterbauelementen ist insofern technisch anspruchsvoll, als einerseits die Prüfkontakte mit Kontaktzustellungen von wenigen 10µm (typischerweise etwa 75µm) an die Kontaktflächen des Halbleiterbauelementes gedrückt werden, und weiters die Druckkammer genau an das Halbleiterbauelement herangeführt werden muss, um ein hinreichend sicheres Abdichten zwischen Halbleiterbauelement und Druckkammer zu erreichen.

Durch Verschleiß der Prüfspitzen beim Serienprüfen von Halbleiterbauelementen wird eine einmal gewählte Position bald verändert, sodass die Druckkammer schon vor den Kontaktspitzen auf dem Halbleiterbauelement aufgesetzt wird und schlussendlich der elektrische Kontakt zu den Kontaktspitzen wegen zu geringem Anpressdruck der Kontaktspitzen mangelhaft wird. In vielen Fällen ist auch eine Berührung zwischen Druckkammer und Halbleiterbauelement nicht erwünscht, da es wegen im Bereich der Berührungsfläche zwischen Druckkammer und Halbleiterbauelement vorhandenen Verunreinigungen (z.B. Partikel, die von Halbleiterscheibenbrüchen herrühren können) zu Beschädigungen des Halbleiterbauelementes (Chip), ganz gleich ob dieser schon aus der Halbleiterscheibe herausgetrennt worden ist oder nicht, kommen kann.

Eine Vorrichtung zum Hochspannungsprüfen von Halbleiterbauelementen ist auch aus der DE 196 30 316 A1 bekannt.

Der Erfindung liegt die Aufgabe zugrunde, eine Vorrichtung, wie sie aus der AT 412 175 B bekannt und vorstehend beschrieben ist, so weiter zu gestalten, dass eine Kombination von Druckkammer mit einer Nadelkarte in vorteilhafter Weise möglich ist.

Gelöst wird diese Aufgabe erfindungsgemäß mit einer Vorrichtung, welche die Merkmale von Anspruch 1 aufweist.

Bevorzugte und vorteilhafte Ausgestaltungen der Erfindung sind Gegenstand der Unteransprüche.

Bei der Erfindung weist die Druckkammer, die mit einer Nadelkarte kombiniert ist, wenigstens einen mit der Nadelkarte verbundenen und gegenüber dieser nicht beweglichen Teil und wenigstens einen senkrecht zur Ebene der Nadelkarte relativ zur Nadelkarte beweglichen, als Ringdichtung dienenden Teil auf. So kann die Druckkammer beim Zustellen der Kontakte der Nadelkarte mit ihrem (wenigstens einen) beweglichen Teil Bewegungen des Halbleiterbauelementes (Chip oder Halbleiterscheibe) folgen.

Erfindungsgemäß ist zusätzlich zwischen der der Halbleiterscheibe zugekehrten Stirnfläche des beweglichen Teils der Druckkammer und der Halbleiterscheibe ein Spalt, in dem ein Luftlager ausgebildet ist, vorgesehen.

Auf diese Weise wird der bewegliche Teil der Druckkammer (Ringdichtung) schwebend über der Oberfläche des Halbleiterbauelementes (Halbleiterscheibe oder Chip) gehalten. Gaslager, wie sie hier verwendet werden, haben die Eigenschaft bei enger werdendem Spalt hohe Lagerkräfte aufzubauen und damit einem (weiteren) Verengen des Spaltes entgegenzuwirken. Damit können Berührungen zwischen der Ringdichtung und der Oberfläche des Halbleiterbauelementes (Wafer-Oberfäche) und somit das Risiko von Beschädigungen des Halbleiterbauelementes mit Zuverlässigkeit vermieden werden.

Die bewegliche Ringdichtung, also der wenigstens eine bewegliche Teil der Druckkammer der Vorrichtung gemäß der vorliegenden Erfindung, kann Änderungen bei der Kontaktzustellung folgen und auch einen Verschleiß der Kontakte der Prüfnadeln ausgleichen. So ist stets eine für das Verschließen der Druckkammer gegenüber dem Halbleiterbauelement richtige Lage möglich.

In einer Ausführungsform der Erfindung wird der bewegliche Teil (Ringdichtung) der Druckkammer durch Federn in die Richtung auf das Halbleiterbauelement, auf das die Druckkammer anzulegen ist, hin belastet und so eine Abdichtung zwischen Druckkammer und Halbleiterbauelement zuverlässig hergestellt. Man hat es in der Hand, die Gefahr des Beschädigens der Halbleiterscheibe oder des Chips durch Partikel (siehe oben), durch entsprechende Wahl der Federkraft der verwendeten Feder zu verringern.

In einer weiteren Ausführungsform der Vorrichtung gemäß der Erfindung ist sichergestellt, dass der Solldruck in der Druckkammer vor Beginn der Hochspannungsprüfung aufgebaut ist. So wird zuverlässig vermieden, dass es zu Funkenüberschlägen kommt, die unter Umständen unbemerkt bleiben und ein Risiko für einen späteren Ausfall des Halbleiterbauelementes bedeuten können. Um den Druckaufbau in der Druckkammer zu überwachen, kann der erfindungsgemäßen Vorrichtung, insbesondere ihrer Druckkammer, ein elektrischer Drucksensor oder Druckschalter zugeordnet sein, der den Druck im Innenraum der Druckkammer überwacht und bei Nichterreichen eines Mindestdruckes verhindert, dass an das zu prüfende Halbleiterbauelement Hochspannung angelegt wird. Ein solcher Drucksensor oder Druckschalter kann entweder direkt in die Druckkammer eingebaut sein. In einer anderen Ausführungsform kann der Drucksensor oder Druckschalter über eine aus der Druckkammer herausgeführte Leitung mit dem Innenraum der Druckkammer in Verbindung stehen. Schließlich besteht im Rahmen der Erfindung die Möglichkeit den Drucksensor oder Druckschalter in der Zuleitung, über die Druckgas (Druckluft) in die Druckkammer geleitet wird, anzuordnen, sodass auch hier das Nichterreichen eines Solldruckes oder aber ein Druckabfall in der Druckkammer erfasst werden kann.

Weitere Einzelheiten und Merkmale der Erfindung ergeben sich aus der nachstehenden Beschreibung bevorzugter an Hand der schematisch dargestellten Ausführungsbeispiele. Es zeigen:
- Fig. 1: eine Vorrichtung der gattungsgemäßen Art, wie sie aus der AT 412 175 B bekannt ist,
- Fig. 2: schematisch das Problem, das mit der Erfindung gelöst wird,
- Fig. 3: eine gattungsgemäße Ausführungsform einer Vorrichtung und
- Fig. 4: eine zweite Ausführungsform einer erfindungsgemäßen Vorrichtung.

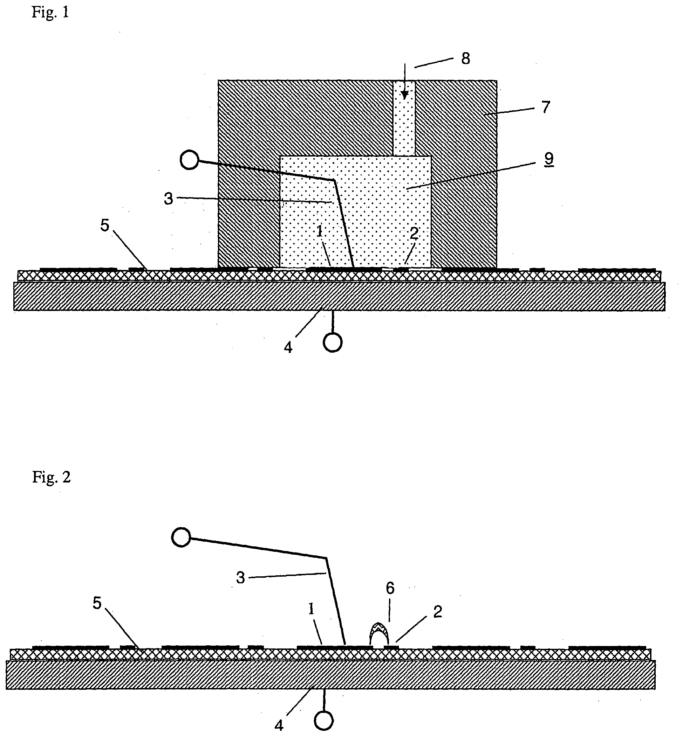

Bei der (bekannten) Vorrichtung gemäß Fig. 1 ist eine Halbleiterscheibe 5 vorgesehen, in der mehrere Chips 10 vorgesehen, aber von dieser Halbleiterscheibe 5 noch nicht getrennt, also noch nicht herausgebrochen worden sind. Jeder Chip 10 hat in Fig. 1 schematisiert dargestellt, Kontaktflächen 1 und 2. Um den Chip 10 zu prüfen, wird über eine Prüfnadel 3, die an die Kontaktfläche 1 des Chips angelegt wird, einerseits und über eine elektrische Kontaktierung 4 auf der Chiprückseite und eine sich in der Chipstruktur befindliche, elektrisch leitfähige Verbindung anderseits, eine Prüfspannung angelegt, indem über die Prüfnadel 3 und die Kontaktierung 4 elektrische Hochspannung angelegt wird.

Wenn Hochspannung angelegt wird, kann es abhängig von der Chipgeometrie und der Höhe der Prüfspannung zwischen den Kontaktflächen 1 und 2, wie in Fig. 2 angedeutet, zu unerwünschten Funkenüberschlägen 6 zwischen Kontaktflächen 1 und 2 über die Atmosphäre (Luft) kommen.

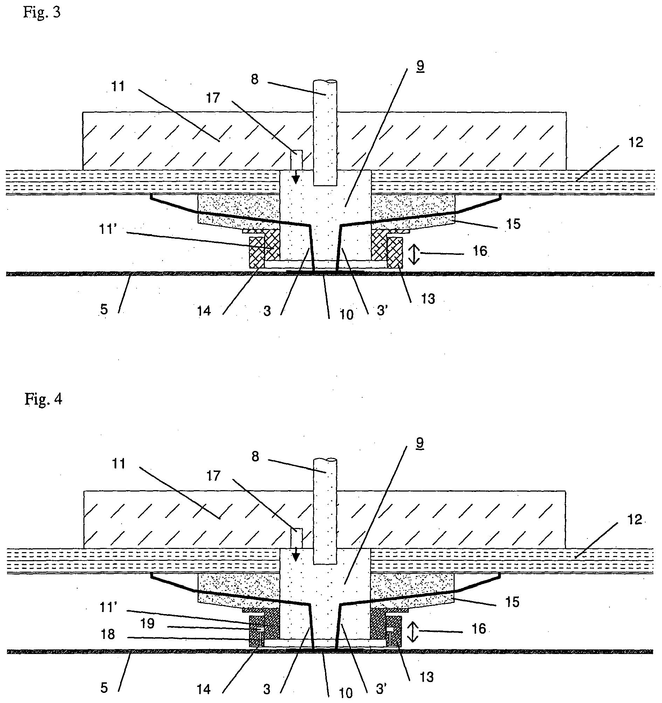

In anderen Messanordnungen kann die Hochspannung zum Zwecke des Prüfens über Kontaktnadeln 3, 3' ausschließlich an die Oberseite des Chips angelegt werden (wie z.B. in Fig. 3 gezeigt). Hierbei treten hohe Feldstärken und damit die Gefahr von Funkenüberschlägen nicht nur zwischen Kontaktflächen 1, 2 des Chips, sondern auch zwischen den Kontaktnadeln 3, 3' selbst auf. Da sich bei einer Ausführungsform der Erfindung die Bereiche (z.B. Spitzen) der Kontaktnadeln 3, 3' innerhalb der erfindungsgemäß vorgesehenen Druckkammer 7 befinden, lassen sich mit der erfindungsgemäßen Vorrichtung auch Funkenüberschläge zwischen den Nadeln verhindern.

Bei der aus der AT 412 175 B bekannten Vorrichtung wird über den zu prüfenden Bereich der Halbleiterscheibe 5 (den zu prüfenden Chip 10 in dieser) eine Druckkammer 7 in Stellung gebracht, deren Innenraum 9 über eine Druckgaszuführung 8 mit Druck beaufschlagt wird. Die Druckkammer 7 ist zur Chipoberfläche hin offen. Nach dem Aufsetzen der Druckkammer 7 auf die Halbleiterscheibe 5 wird über die Druckgaszuführung 8 im Innenraum 9 der Druckkammer 7 oberhalb des Chips 10 Überdruck aufgebaut.

Bei der in Fig. 3 gezeigten Ausführungsform einer Vorrichtung besteht die Druckkammer 7 aus zwei mit der Nadelkarte 12 fix verbundenen Teilen 11 und 11', wobei die Teile 11 und 11' an einander gegenüberliegenden Seiten der Nadelkarte 12 angeordnet sind. In dem auf der, bezogen auf die zu prüfende Halbleiterscheibe 5 abgekehrten Seite der Nadelkarte 12 angeordneten Teil 11 der Druckkammer 7, ist eine Gaszuführung 8 für die Druckkammer 7, die in den Innenraum 9 der Druckkammer 7 mündet, vorgesehen. Der an der der Halbleiterscheibe 5 zugekehrten Seite der Nadelkarte 12 angeordnete Teil 11' der Druckkammer 7 ist an der Nadelkarte 12 über einen Ring 15 aus elektrisch isolierendem Werkstoff befestigt. Durch den Ring 15 aus elektrisch isolierendem Werkstoff sind die Prüfnadeln 3 und 3' zum elektrischen Kontaktieren des Chips 10, der im gezeigten Ausführungsbeispiel noch in der Halbleiterscheibe 5 ist, also aus dieser nicht herausgebrochen worden ist, geführt.

Die Druckkammer 7 besitzt in der in Fig. 3 gezeigten Ausführungsform weiters wenigstens einen ringförmigen Teil 13, der in Richtung des Doppelpfeiles 16, gegenüber dem mit der Nadelkarte 12 verbundenen Teilen 11 und 11' der Druckkammer 7, also im Wesentlichen senkrecht zur Ebene der Halbleiterscheibe 5 und der Nadelkarte 12 verstellbar ist. Zwischen dem Teil 11' der Druckkammer 7, der auf der der Halbleiterscheibe 5 zugekehrten Seite der Nadelkarte 12 angeordnet ist, und dem beweglichen Teil 13 der Druckkammer 7 ist (wenigstens) eine (nicht gezeigte) Feder vorgesehen, die den als Ringdichtung dienenden Teil 13 der Druckkammer 7 in Richtung auf die Halbleiterscheibe 5 hin belastet.

Bei der in Fig. 4 gezeigten Ausführungsform einer erfindungsgemäßen Vorrichtung ist im Spalt 14 zwischen dem beweglichen Teil 13 und der Halbleiterscheibe 5 ein Luftlager ausgebildet, das dadurch gebildet wird, dass Druckluft durch den Spalt 14 zwischen dem beweglichen Teil 13 und der Oberseite der Halbleiterscheibe 5 austritt. Durch dieses Luftlager wird, wie oben erläutert, erreicht, dass der ringförmige Teil 13 dichtend aber im Abstand von der Oberseite der Halbleiterscheibe 5 gehalten wird. Das Luftlager im Spalt 14 wird über einen ringförmigen Kanal 19 (radial nach innen offene Nut im Teil 13) und achsparallele Kanäle 18 mit Druckluft beaufschlagt. Die Kanäle 18 münden in, z.B. kreisrunden, Vertiefungen in der der Halbleiterscheibe 5 zugewendeten, kreisringförmigen Stirnfläche des beweglichen Teils 13. Diese Vertiefungen sind beispielsweise über die Stirnfläche des Teiles 13 gleichmäßig verteilt angeordnet. Die Druckluft kann dem Innenraum 9 der Druckkammer 7 entnommen oder über gesonderte (nicht gezeigte Leitungen) dem Kanal 19 zugeführt werden.

Im Unterschied zu einer z.B. aus der DE 102006018474 A1 bekannten Vorrichtung, bei welcher ein Gasspalt mittels mechanischen Stellgliedern und entsprechend zugeordneten Abstandssensoren eingestellt wird, ist ein im Rahmen der Erfindung verwendetes "schwebendes" Luftlager besonders vorteilhaft. Das im Rahmen der Erfindung verwendete (statische) Luftlager zeichnet sich dadurch aus, dass durch Drosselung eine spaltabhängige Lagerkraft entsteht, die im Zusammenspiel mit der Belastung der Dichtung mittels Feder in Richtung der Halbleiterscheibe 5 zu einem sich selbstregelnd einstellenden Dichtspalt führt - dies ohne zusätzliche Mittel wie Stellglieder oder Abstandssensoren, welche zur Stabilisierung eines Gasspaltes z.B. gemäß der DE 102006018474 A1 notwendig sind.

Bei der in Fig. 3 und bei der in Fig. 4 gezeigten Ausführungsform der Vorrichtung ist dem Innenraum 9 der Druckkammer 7 ein Drucksensor 17 (symbolisiert dargestellt) zugeordnet. Wie bereits oben erwähnt, kann der Drucksensor 17 auch über eine Leitung mit dem Innenraum 9 der Druckkammer 7 verbunden sein. Der Drucksensor 17 (oder ein sinngemäß wirkender Druckschalter) kann aber auch der Gaszuführung 8 zugeordnet sein. Wesentlich ist, dass der Drucksensor 17 oder Druckschalter den Druck im Innenraum 9 der Druckkammer 7 erfasst und das Anlegen der Prüfspannung erst erlaubt, wenn der vorgeschriebene Mindestdruck, der hinreicht bei der Prüfspannung, Funkenüberschläge 6 (Fig. 2)zu verhindern, erreicht ist.

Das Überwachen des Druckes in dem Innenraum 9 der Druckkammer 7 mit Hilfe eines Drucksensor 17 oder eines Druckschalters, ist insbesondere beim Verwenden der erfindungsgemäßen Vorrichtung beim automatisierten Prüfen hoher Stückzahlen von Halbleiterbauelementen vorteilhaft, da jedenfalls sichergestellt ist, dass der Solldruck vor Beginn der Hochspannungsprüfung in der Druckkammer 7 immer auch tatsächlich aufgebaut worden ist.

Im Rahmen der Erfindung ist auch eine Ausführungsform der Vorrichtung in Betracht gezogen, bei der an einer Nadelkarte 12 mehr als eine Druckkammer 7 mit beweglichem Teil 13 (Ringdichtung) angeordnet sind.

Mit der erfindungsgemäßen Vorrichtung ist es möglich ein einzelnes Halbleiterbauelement (Chip 10) oder zugleich zwei oder mehrere Halbleiterbauelemente einer Hochspannungsprüfung zu unterziehen.

Zusammenfassend kann ein Ausführungsbeispiel der Erfindung wie folgt beschrieben werden.

Eine Vorrichtung zum Vermeiden von Funkenüberschlägen beim Hochspannungsprüfen von Halbleiterbauelementen (Chips 10) auf Halbleiterscheiben 5 umfasst eine der Halbleiterscheibe 5 dichtend zustellbare Druckkammer 7 mit einer Druckgaszuführung 8, sodass der Innenraum 9 der Druckkammer 7 unter Überdruck gesetzt und so die Zündspannung für einen Funkenüberschlag zwischen Kontaktflächen 1, 2 höher ist, als die maximal anzulegende Prüfspannung. Die Druckkammer 7 ist mit einer Nadelkarte 12 mit Kontaktnadeln 3 verbunden. Die Druckkammer 7 besitzt einen beweglichen Teil 13, der relativ zu den der Nadelkarte 12 verbundenen Teilen 11 und 11' der Druckkammer 7 beweglich ist. Der bewegliche Teil 13 der Druckkammer 7 wird durch ein Luftlager im Spalt 14 zwischen der Druckkammer 7 und der Halbleiterscheibe 5 dichtend im Abstand von der Oberfläche der Halbleiterscheibe 5 gehalten. Im Rahmen der Erfindung ist wenigstens ein relativ zur Nadelkarte 12 frei bewegliches Teil 13 bzw. mittels Federkraft in Richtung Halbleiterscheibe 5 gedrücktes Teil 13 vorgesehen.

## Patentansprüche

1. Vorrichtung zum elektrischen Hochspannungsprüfen von einem, zwei oder mehreren Halbleiterbauelementen (5) umfassend eine Druckkammer (7) deren Innenraum (9) über eine Druckgasleitung (8) unter Überdruck gesetzt werden kann, wobei die Druckkammer (7) an einer Nadelkarte (12) mit Prüfnadeln (3) angeordnet ist, **dadurch gekennzeichnet, dass** die Druckkammer (7) wenigstens einen Teil (13) aufweist, der relativ zur Nadelkarte (12) beweglich ist und dass zwischen der der Halbleiterscheibe (5) zugekehrten Stirnfläche des beweglichen Teils (13) der Druckkammer (7) und der Halbleiterscheibe (5) ein Spalt (14), in dem ein Luftlager ausgebildet ist, vorgesehen ist.

2. Vorrichtung nach Anspruch 1, **dadurch gekennzeichnet, dass** der bewegliche Teil (13) als Ringdichtung ausgebildet ist.

3. Vorrichtung nach Anspruch 1 oder 2, **dadurch gekennzeichnet, dass** der Teil 13 der Druckkammer (7) im Wesentlichen senkrecht zur Ebene der Nadelkarte (12) bzw. des zu prüfenden Halbleiterbauelementes (5) beweglich ist.

4. Vorrichtung nach einem der Ansprüche 1 bis 3, **dadurch gekennzeichnet, dass** der mit der Nadelkarte (12) verbundene Teil der Druckkammer (7) zwei Teile (11 und 11') aufweist, die auf einander gegenüberliegenden Seiten der Nadelkarte (12) angeordnet sind.

5. Vorrichtung nach einem der Ansprüche 1 bis 4, **dadurch gekennzeichnet, dass** der an der dem zu prüfenden Halbleiterbauelement (5) zugewendeten Seite der Nadelkarte (12) angeordnete Teil (11') der Druckkammer (7) an der Nadelkarte (12) über einen Ring (15) aus elektrisch isolierendem Werkstoff angeordnet ist, und dass die Prüfnadeln (3) der Nadelkarte (12) durch den Ring (15) geführt sind.

6. Vorrichtung nach einem der Ansprüche 1 bis 5, **dadurch gekennzeichnet, dass** zwischen dem mit der Nadelkarte (12) verbundenem Teil (11') der Druckkammer (7) und dem beweglichen Teil (13) der Druckkammer (7) wenigstens eine Feder vorgesehen ist.

7. Vorrichtung nach einem der Ansprüche 1 bis 6, **dadurch gekennzeichnet, dass** der Druckkammer (7) eine Einrichtung (17) zum Überwachen des Druckes im Innenraum (9) der Druckkammer (7) zugeordnet ist.

8. Vorrichtung nach Anspruch 7, **dadurch gekennzeichnet, dass** die Einrichtung ein Druckschalter oder ein Drucksensor (17) ist.

9. Vorrichtung nach Anspruch 7 oder 8, **dadurch gekennzeichnet, dass** die Einrichtung (17) zum Überwachen des Druckes im Innenraum (9) der Druckkammer (7) unmittelbar zugeordnet ist.

10. Vorrichtung nach einem der Ansprüche 7 bis 9, **dadurch gekennzeichnet, dass** die Einrichtung (17) zum Überwachen des Druckes im Innenraum (9) der Druckkammer (7) mit dem Innenraum (9) über eine Leitung verbunden ist.

11. Vorrichtung nach einem der Ansprüche 7 bis 10, **dadurch gekennzeichnet, dass** die Einrichtung (17) zum Überwachen des Druckes im Innenraum (9) der Druckkammer (7) der Druckgaszuführung (8) zugeordnet ist.

## Claims

1. Device for electrical high-voltage testing of one, two, or more semiconductor components (5) comprising a pressure chamber (7) whose interior (9) can be placed under an overpressure via a pressurized gas line (8), wherein the pressure chamber (7) is located on a probe card (12) with test probes (3), **characterized in that** the pressure chamber (7) has at least one part (13) that can be moved relative to the probe card (12), and there is a gap (14), in which an air bearing is formed, between the front surface of the movable part (13) of the pressure chamber (7) facing the semiconductor wafer (5) and the semiconductor wafer (5).

2. Device according to claim 1, **characterized in that** the movable part (13) is made as a ring seal.

3. Device according to claim 1 or 2, **characterized in that** the part 13 of the pressure chamber (7) can be moved essentially perpendicular to the plane of the probe card (12) or the semiconductor component (5) that is to be tested.

4. Device according to any one of claims 1 to 3, **characterized in that** the part of the pressure chamber (7) connected to the probe card (12) has two parts (11 and 11') that are located on sides of the probe card (12) that are opposite to one another.

5. Device according to any one of claims 1 to 4, **characterized in that** the part (11') of the pressure chamber (7) located on the side of the probe card (12) facing the semiconductor component (5) that is to be tested is located on the probe card (12) above a ring (15) of electrically insulating material, and the test probes (3) of the probe card (12) are directed through the ring (15).

6. Device according to any one of claims 1 to 5, **characterized in that** there is at least one spring between the part (11') of the pressure chamber (7) connected to the probe card (12) and the movable part (13) of the pressure chamber (7).

7. Device according to any one of claims 1 to 6, **characterized in that** the pressure chamber (7) is assigned an apparatus (17) for monitoring the pressure in the interior (9) of the pressure chamber (7).

8. Device according to claim 7, **characterized in that** the apparatus is a pressure switch or a pressure sensor (17).

9. Device according to claim 7 or 8, **characterized in that** the apparatus (17) for monitoring the pressure in the interior (9) is assigned directly to the pressure chamber (7).

10. Device according to any one of claims 7 to 9, **characterized in that** the apparatus (17) for monitoring the pressure in the interior (9) of the pressure chamber (7) is connected to the interior (9) via a line.

11. Device according to any one of claims 7 to 10, **characterized in that** the apparatus (17) for monitoring the pressure in the interior (9) of the pressure chamber (7) is assigned to the pressurized gas feed (8).

## Revendications

1. Dispositif pour le test électrique à haute tension d'un, deux ou plusieurs composants à semi-conducteurs (5), comprenant une chambre de pression (7) dont l'espace intérieur (9) peut être mis sous surpression par une conduite de gaz sous pression (8), la chambre de pression (7) étant disposée sur une carte à pointes (12) munie de pointes de test (3), **caractérisé en ce que** la chambre de pression (7) présente au moins une partie (13) qui est mobile par rapport à la carte à pointes (12) et qu'une fente (14), dans laquelle est formé un palier à air, est prévue entre la face frontale, tournée vers la plaquette à semi-conducteurs (5), de la partie mobile (13) de la chambre de pression (7) et la plaquette à semi-conducteurs (5) .

2. Dispositif selon la revendication 1, **caractérisé en ce que** la partie mobile (13) est réalisée sous la forme d'un joint annulaire.

3. Dispositif selon la revendication 1 ou 2, **caractérisé en ce que** la partie 13 de la chambre de pression (7) peut être déplacée sensiblement perpendiculairement au plan de la carte à pointes (12) ou du composant à semi-conducteurs (5) à tester.

4. Dispositif selon l'une des revendications 1 à 3, **caractérisé en ce que** la partie de la chambre de pression (7) reliée à la carte à pointes (12) présente deux parties (11 et 11') qui sont disposées sur des côtés opposés de la carte à pointes (12).

5. Dispositif selon l'une des revendications 1 à 4, **caractérisé en ce que** la partie (11') de la chambre de pression (7) qui est disposée sur le côté de la carte à pointes (12) tourné vers le composant à semi-conducteurs (5) à tester est disposée sur la carte à pointes (12) par l'intermédiaire d'une bague (15) en matériau électriquement isolant, et que les pointes de test (3) de la carte à pointes (12) sont guidées à travers la bague (15).

6. Dispositif selon l'une des revendications 1 à 5, **caractérisé en ce qu'**au moins un ressort est prévu entre la partie (11') de la chambre de pression (7) reliée à la carte à pointes (12) et la partie mobile (13) de la chambre de pression (7).

7. Dispositif selon l'une des revendications 1 à 6, **caractérisé en ce qu'**un moyen (17) pour surveiller la pression dans l'espace intérieur (9) de la chambre de pression (7) est associé à la chambre de pression (7).

8. Dispositif selon la revendication 7, **caractérisé en ce que** le moyen est un pressostat ou un capteur de pression (17).

9. Dispositif selon la revendication 7 ou 8, **caractérisé en ce que** le moyen (17) pour surveiller la pression dans l'espace intérieur (9) de la chambre de pression (7) est directement associé à celle-ci.

10. Dispositif selon l'une des revendications 7 à 9, **caractérisé en ce que** le moyen (17) pour surveiller la pression dans l'espace intérieur (9) de la chambre de pression (7) est relié à l'espace intérieur (9) par une conduite.

11. Dispositif selon l'une des revendications 7 à 10, **caractérisé en ce que** le moyen (17) pour surveiller la pression dans l'espace intérieur (9) de la chambre de pression (7) est associé à l'alimentation en gaz sous pression (8).
